# EUROPÄISCHE PATENTSCHRIFT

(11) **EP 2 897 186 B1**
(45) Veröffentlichungstag und Bekanntmachung des Hinweises auf die Patenterteilung: **26.12.2018**
(21) Anmeldenummer: 14152021.3
(22) Anmeldetag: 21.01.2014
(51) Int. Cl.: H01L 51/52

(54) **UV-Schutzfolie für OLEDs**
UV protection film for OLEDs
Feuille de protection contre les UV pour OLED

(43) Veröffentlichungstag der Anmeldung: 22.07.2015
(73) Patentinhaber: Covestro Deutschland AG, 51373 Leverkusen (DE); OSRAM Opto Semiconductors GmbH, 93055 Regensburg (DE)
(72) Erfinder: Pudleiner, Heinz, 47800 Krefeld (DE); Meyer, Klaus, 41539 Dormagen (DE); Krummacher, Benjamin, 93051 Regensburg (DE); Schicktanz, Simon, 93049 Regensburg (DE); Setz, Daniel Steffen, 71034 Böblingen (DE)
(74) Vertreter: Levpat

(56) Entgegenhaltungen:
- DE-A1-102005 040 315
- DE-A1-102006 014 118
- DE-A1-102011 004 703
- US-A1- 2005 147 830
- US-A1- 2012 234 460

## Beschreibung

Die vorliegende Erfindung betrifft ein organisches strahlungsemittierendes Bauelement mit einer zur Strahlungserzeugung ausgebildeten organischen Schicht und einer oder zwei Strahlungsauskoppelseiten, dadurch gekennzeichnet, dass auf der oder den Strahlungsauskoppelseiten des Bauelements eine Kunststofffolie angeordnet ist, welche die Merkmale aufweist:
die Kunststofffolie umfasst mindestens eine erste Schicht einer Kunststoffzusammensetzung enthaltend einen ersten transparenten Kunststoff, sowie transparente, polymere Streuteilchen und mindestens eine zweite Schicht einer Kunststoffzusammensetzung enthaltend einen zweiten transparenten Kunststoff und einen UV-Absorber.

Organische lichtemittierende Dioden (OLEDs) gelten wegen ihres geringen Energieverbrauchs, ihrer Langlebigkeit und hohen Lichtqualität als Lichtquelle der Zukunft. Ein großer Teil des in OLEDs erzeugten Lichts wird allerdings nicht zum Betrachter, d.h. in einer nutzbaren Weise, ausgekoppelt. Ursachen hierfür sind sowohl die optischen Eigenschaften der in OLED verwendeten Materialien als auch die des typischerweise als OLED-Substrat verwendeten Glases. Vielmehr wird der nutzbare Lichtstrom durch Wellenleitung und/oder Absorption in den jeweiligen Schichten um einen beträchtlichen Faktor abgeschwächt. Eine Hauptursache hierfür ist der Sprung der optischen Dichte am Übergang von Glas zu Luft. An dieser Grenzfläche kommt es ab einem bestimmten, materialspezifischen (abhängig von Farbe und Substrat) Winkel zur Totalreflexion von Photonen. Diese Photonen können im Weiteren nicht mehr nutzbar gemacht werden.

US2005/147830, DE102006014118 und DE102005040315 offenbaren Diffusor-Sheets bzw. Diffusor-Platten in Flachbildschirmen.

Beispielsweise aus der WO2005/018010, EP1406474, DE102011004703, US2001/0026124 und US2004/0061107 ist prinzipiell bekannt, dass durch den Einsatz von streuenden Elementen die Auskopplungs- bzw. Lichteffizienz einer OLED verbessert werden kann.

Auch die WO2008/014739 und die WO2010/146091 beschreiben strahlungsemmitierende Bauelemente, die eine Auskopplungsfolie umfassen. Durch den Einsatz von speziellen Auskopplungsfolien aus Kunststoff kann eine Steigerung der Lichteffizienz und der Homogenität der Strahlungsleistung erreicht werden. Dazu ist es allerdings erforderlich, dass die Folien eine bestimmte Oberflächenstrukturierung aufweisen, die aufwendig aufgebracht werden muss. Zudem beeinflussen die im Stand der Technik vorgesehenen Lösungen durch die Strukturierung der Oberfläche der Auskopplungsfolie auch das Erscheinungsbild der Bauelemente wesentlich. So ergibt sich im ausgeschalteten Zustand eine unerwünschte milchige und diffus reflektierende Oberfläche.

Des Weiteren wird für die strahlungsemmitierenden Bauelemente nach dem Stand der Technik, insbesondere für großflächige Anwendungen, beobachtet, dass der Farbeindruck vom Blickwinkel des Betrachters der Lichtquelle abhängig (Colour-Shift) ist. Vorteilhaft wäre jedoch ein konstanter Farbeindruck unabhängig vom Blickwinkel des Betrachters.

Wie oben bereits erwähnt, enthalten OLEDs typischerweise Glas als Trägermaterial. Dieses weist jedoch noch einige weitere nicht vorteilhafte Eigenschaften auf: Glas ist in einem solchen Maße UV-durchlässig, dass Schädigungen der aktiven - zum Teil photochemisch empfindlichen - organischen Materialien durch UV Licht nicht ausgeschlossen werden können. Ferner neigt Glas bei mechanischer Belastung zu Splitterbruch, was ein potentielles Sicherheitsrisiko darstellt.

Die der vorliegenden Erfindung zu Grunde liegende Aufgabe war es daher, ein organisches strahlungsemittierende Bauelemente bereitzustellen, das eine hohe Auskopplungseffizienz gewährleistet und gleichzeitig auch im ausgeschalteten Zustand ein gutes optisches Erscheinungsbild erzeugt. Zudem sollte ein konstanter, Farbeindruck gewährleistet werden, der möglichst unabhängig vom Betrachterwinkel ist. Gleichzeitig soll das Bauelement auch kratzfest sein, eine UV Schutz für die aktiven organischen Materialien zur Verfügung stellen und das Sicherheitsrisiko von Glas als Trägermaterial minimieren.

Diese Aufgabe wird erfindungsgemäß gelöst durch ein organisches strahlungsemittierendes Bauelement mit einer zur Strahlungserzeugung ausgebildeten organischen Schicht und einer oder zwei Strahlungsauskoppelseiten, dadurch gekennzeichnet, dass auf der oder den Strahlungsauskoppelseiten des Bauelements eine Kunststofffolie angeordnet ist, welche die Merkmale aufweist:
die Kunststofffolie umfasst mindestens eine erste Schicht einer Kunststoffzusammensetzung enthaltend einen ersten transparenten Kunststoff, sowie 5 bis 9 Gew.-% transparenter, polymerer Streuteilchen, bezogen auf die Gesamtmasse der ersten Schicht, und mindestens eine zweite Schicht einer Kunststoffzusammensetzung enthaltend einen zweiten transparenten Kunststoff und 0,01 bis 5 Gew.-% eines UV-Absorbers, bezogen auf die Gesamtmasse der zweiten Schicht, wobei der Brechungsindex der zweiten Schicht um wenigstens 0,6% vom Brechungsindex der ersten Schicht abweicht,
der Brechungsindex der zweiten Schicht ist geringer als der der ersten Schicht, der transparente Kunststoff der ersten Schicht enthält Polycarbonat und der transparente Kunststoff der zweiten Schicht ist ein Polyalkyl(meth)acrylat.

Alle genannten Brechungsindices sind bestimmt nach DIN EN IOS 489 (bei 23°C und 589 nm).

Überraschender Weise hat sich gezeigt, dass die Kunststofffolien beim erfindungsgemäßen Einsatz als Auskopplungsfolien in OLEDS zu einer gegenüber dem Stand der Technik erhöhten Auskopplungseffizienz führen. Auf Grund der glatten und glänzenden Oberfläche der Kunststofffolien weisen damit ausgestattete OLEDs auch im ausgeschalteten Zustand ansprechende optische Eigenschaften auf. Weiterhin hat sich überraschend gezeigt, dass auch der Farbeindruck deutlich konstanter und weniger abhängig vom Blickwinkel des Betrachters ist. Mit der Kunststofffolie ausgestattete OLEDs zeigen zudem eine verbesserte Beständigkeit gegen UV Strahlung und sind kratzfest. Durch die Kunststofffolie wird auch das Glas des Trägermaterials in einem Verbund zusammengehalten und somit das Sicherheitsrisiko eines Splitterbruchs verringert.

In der erfindungsgemäßen Ausführungsform weicht der Brechungsindex der zweiten Schicht um wenigstens 0,6%, besonders bevorzugt wenigstens 3% und ganz besonders bevorzugt wenigstens 6% vom Brechungsindex der ersten Schicht ab. Bevorzugt weicht der Brechungsindex der zweiten Schicht um maximal 20%, besonders bevorzugt maximal 15% und ganz besonders bevorzugt maximal 10% vom Brechungsindex der ersten Schicht ab.

Der Brechungsindex der zweiten Schicht ist erfindungsgemäß geringer als der der ersten Schicht. In der erfindungsgemäßen Ausführungsform der Erfindung ist der Brechungsindex der zweiten Schicht um wenigstens 0,6%, besonders bevorzugt wenigstens 3% und ganz besonders bevorzugt wenigstens 6% geringer als der Brechungsindex der ersten Schicht. Bevorzugt ist der Brechungsindex der zweiten Schicht um maximal 20%, besonders bevorzugt maximal 15% und ganz besonders bevorzugt maximal 10% geringer als der Brechungsindex der ersten Schicht

In einer ebenfalls bevorzugten Ausführungsform der Erfindung weicht der Brechungsindex der zweiten Schicht um wenigstens 0,01, besonders bevorzugt wenigstens 0,04 und ganz besonders bevorzugt wenigstens 0,09 Einheiten vom Brechungsindex der ersten Schicht ab. Bevorzugt weicht der Brechungsindex der zweiten Schicht um maximal 0,30, besonders bevorzugt maximal 0,25 und ganz besonders bevorzugt maximal 0,15 Einheiten vom Brechungsindex der ersten Schicht ab.

In einer weiteren bevorzugten Ausführungsform der Erfindung ist der Brechungsindex der zweiten Schicht um wenigstens 0,01, besonders bevorzugt wenigstens 0,04 und ganz besonders bevorzugt wenigstens 0,09 Einheiten geringer als der Brechungsindex der ersten Schicht. Bevorzugt ist der Brechungsindex der zweiten Schicht um maximal 0,30, besonders bevorzugt maximal 0,25 und ganz besonders bevorzugt maximal 0,15 Einheiten geringer als der Brechungsindex der ersten Schicht

Der transparente Kunststoff der ersten Schicht enthält Polycarbonat und ist beispielsweise ausgewählt aus der Gruppe Polycarbonat, Polycarbonat/Polyester-Blends, z.B. PC/PET, Polycarbonat/Polycyclohexylmethanolcyclohexandicarboxylat (PCCD; Xylecs® von der Fa. Sabic IP) und Polycarbonat/Polybutylenterephthalat (PBT) Blends.

In einer bevorzugten Ausführungsform der Erfindung ist der transparente Kunststoff der ersten Schicht Polycarbonat, ein Polycarbonat/Polyester-Blend, ein Polycarbonat/Polycyclohexylmethanolcyclohexandicarboxylat Blend oder ein Polycarbonat/Polybutylenterephthalat Blend, besonders bevorzugt Polycarbonat.

Geeignete Polycarbonate sind alle bekannten Polycarbonate. Dies können Homopolycarbonate, Copolycarbonate und thermoplastische Polyestercarbonate sein.

Sie haben bevorzugt mittlere Molekulargewichte M̅_{w} von 18.000 bis 40.000, vorzugsweise von 22.000 bis 36.000 und insbesondere von 24.000 bis 33.000, ermittelt durch Messung der relativen Lösungsviskosität in Dichlormethan oder in Mischungen gleicher Gewichtsmengen Phenol/o-Dichlorbenzol geeicht durch Lichtstreuung.

Zur Herstellung von Polycarbonaten sei beispielhaft auf "Schnell, Chemistry and Physics of Polycarbonats, Polymer Reviews, Vol. 9, Interscience Publishers, New York, London, Sydney 1964", und auf "D.C. PREVORSEK, B.T. DEBONA and Y. KESTEN, Corporate Research Center, Allied Chemical Corporation, Moristown, New Jersey 07960, 'Synthesis of Poly(ester)carbonate Copolymers' in Journal of Polymer Science, Polymer Chemistry Edition, Vol. 19, 75-90 (1980)", und auf "D. Freitag, U. Grigo, P.R. Müller, N. Nouvertne, BAYER AG, 'Polycarbonates' in Encyclopedia of Polymer Science and Engineering, Vol. 11, Second Edition, 1988, Seiten 648-718" und schließlich auf "Dres. U. Grigo, K. Kircher und P.R. Müller 'Polycarbonate' in Becker/Braun, Kunststoff-Handbuch, Band 3/1, Polycarbonate, Polyacetale, Polyester, Celluloseester, Carl Hanser Verlag München, Wien 1992, Seiten 117-299" verwiesen.

Die Herstellung der Polycarbonate erfolgt vorzugsweise nach dem Phasengrenzflächenverfahren oder dem Schmelze-Umesterungsverfahren und wird im Folgenden beispielhaft an dem Phasengrenzflächenverfahren beschrieben.

Als Ausgangsverbindungen bevorzugt einzusetzende Verbindungen sind Bisphenole der allgemeinen Formel

HO-R-OH,

worin R ein divalenter organischer Rest mit 6 bis 30 Kohlenstoffatomen ist, der eine oder mehrere aromatische Gruppen enthält.

Beispiele solcher Verbindungen sind Bisphenole, die zu der Gruppe der Dihydroxydiphenyle, Bis(hydroxyphenyl)alkane, Indanbisphenole, Bis(hydroxyphenyl)ether, Bis(hydroxyphenyl)sulfone, Bis(hydroxyphenyl)ketone und α,α'-Bis(hydroxyphenyl)-diisopropylbenzole gehören.

Besonders bevorzugte Bisphenole, die zu den vorgenannten Verbindungsgruppen gehören, sind Bisphenol-A, Tetraalkylbisphenol-A, 4,4-(meta-Phenylendiisopropyl) diphenol (Bisphenol M), 4,4-(para-Phenylendiisopropyl) diphenol, 1,1-Bis-(4-hydroxyphenyl)-3,3,5-trimethylcyclohexan (BP-TMC) sowie gegebenenfalls deren Gemische.

Bevorzugt werden die erfindungsgemäß einzusetzenden Bisphenolverbindungen mit Kohlensäureverbindungen, insbesondere Phosgen, oder beim Schmelzeumesterungsprozess mit Diphenylcarbonat bzw. Dimethylcarbonat, umgesetzt.

Polyestercarbonate werden bevorzugt durch Umsetzung der bereits genannten Bisphenole, mindestens einer aromatischen Dicarbonsäure und gegebenenfalls Kohlensäureäquivalente erhalten. Geeignete aromatische Dicarbonsäuren sind beispielsweise Phthalsäure, Terephthalsäure, Isophthalsäure, 3,3'- oder 4,4'-Diphenyldicarbonsäure und Benzophenondicarbonsäuren. Ein Teil, bis zu 80 Mol.-%, vorzugsweise von 20 bis 50 Mol-% der Carbonatgruppen in den Polycarbonaten können durch aromatische Dicarbonsäureester-Gruppen ersetzt sein.

Beim Phasengrenzflächenverfahren verwendete inerte organische Lösungsmittel sind beispielsweise Dichlormethan, die verschiedenen Dichlorethane und Chlorpropanverbindungen, Tetrachlormethan, Trichlormethan, Chlorbenzol und Chlortoluol, vorzugsweise werden Chlorbenzol oder Dichlormethan bzw. Gemische aus Dichlormethan und Chlorbenzol eingesetzt.

Die Phasengrenzflächenreaktion kann durch Katalysatoren wie tertiäre Amine, insbesondere N-Alkylpiperidine oder Oniumsalze beschleunigt werden. Bevorzugt werden Tributylamin, Triethylamin und N-Ethylpiperidin verwendet. Im Falle des Schmelzeumesterungsprozesses werden bevorzugt die in DE-A 4 238 123 genannten Katalysatoren verwendet.

Die Polycarbonate können durch den Einsatz geringer Mengen Verzweiger bewusst und kontrolliert verzweigt werden. Einige geeignete Verzweiger sind: Phloroglucin, 4,6-Dimethyl-2,4,6-tri-(4-hydroxyphenyl)-hepten-2; 4,6-Dimethyl-2,4,6-tri-(4-hydroxyphenyl)-heptan; 1,3,5-Tri-(4-hydroxyphenyl)-benzol; 1,1,1-Tri-(4-hydroxyphenyl)-ethan; Tri-(4-hydroxyphenyl)-phenylmethan; 2,2-Bis-[4,4-bis-(4-hydroxyphenyl)-cyclohexyl]-propan; 2,4-Bis-(4-hydroxyphenyl-isopropyl)-phenol; 2,6-Bis-(2-hydroxy-5'-methylbenzyl)-4-methylphenol; 2-(4-Hydroxyphenyl)-2-(2,4-dihydroxyphenyl)-propan; Hexa-(4-(4-hydroxyphenyl-isopropyl)-phenyl)-orthoterephthalsäureester; Tetra-(4-hydroxyphenyl)-methan; Tetra-(4-(4-hydroxyphenyl-isopropyl)-phenoxy)-methan; α,α,'α"-Tris-(4-hydroxyphenyl)-1,3,5-triisopropylbenzol; 2,4-Dihydroxybenzoesäure; Trimesinsäure; Cyanurchlorid; 3,3-Bis-(3-methyl-4-hydroxyphenyl)-2-oxo-2,3-dihydroindol; 1,4-Bis-(4',4"-dihydroxytriphenyl)-methyl)-benzol und insbesondere: 1,1,1-Tri-(4-hydroxyphenyl)-ethan und Bis-(3-methyl-4-hydroxyphenyl)-2-oxo-2,3-dihydroindol.

Die gegebenenfalls mitzuverwendenden 0,05 bis 2 Mol-%, bezogen auf eingesetzte Diphenole, an Verzweigern bzw. Mischungen der Verzweigern, können mit den Diphenolen zusammen eingesetzt werden aber auch in einem späteren Stadium der Synthese zugegeben werden.

Als Kettenabbrecher werden bevorzugt Phenole wie Phenol, Alkylphenole wie Kresol und 4-tert.-Butylphenol, Chlorphenol, Bromphenol, Cumylphenol oder deren Mischungen verwendet in Mengen von 1 - 20 Mol-%, bevorzugt 2 - 10 Mol-% je Mol Bisphenol. Bevorzugt sind Phenol, 4-tert.-Butylphenol bzw. Cumylphenol.

Kettenabbrecher und Verzweiger können getrennt oder aber auch zusammen mit dem Bisphenol den Synthesen zugesetzt werden.

Die Herstellung der Polycarbonate nach dem Schmelzeumesterungsprozess ist in DE-A 4238 123 beispielhaft beschrieben.

Erfindungsgemäß bevorzugte Polycarbonate für die erste Schicht der Kunststofffolie sind das Homopolycarbonat auf Basis von Bisphenol A, das Homopolycarbonat auf Basis von 1,1-Bis-(4-hydroxyphenyl)-3,3,5-trimethylcyclohexan und die Copolycarbonate auf Basis der beiden Monomere Bisphenol A und 1,1-Bis-(4-hydroxyphenyl)-3,3,5-trimethylcyclohexan.

Der transparente Kunststoff der ersten Schicht ist besonders bevorzugt ein Homopolycarbonat auf Basis von Bisphenol A.

Der Anteil des transparenten Kunststoffs an der Kunststoffzusammensetzung der ersten Schicht liegt bevorzugt bei 85 bis 99,98 Gew.-%, besonders bevorzugt bei 90 Gew.-% bis 99,98 Gew.-% und ganz besonders bevorzugt bei 97,5 Gew.-% bis 99,98 Gew.-%, bezogen auf die Gesamtmasse der ersten Schicht.

Die erste Schicht enthält 5 bis 9 Gew.-% an transparenten, polymeren Streuteilchen, bezogen auf die Gesamtmasse der ersten Schicht.

Der Brechungsindex der Streuteilchen weicht bevorzugt um 0,6 % oder mehr, besonders bevorzugt um 3 % oder mehr und mit besonderem Vorteil um 6 % oder mehr vom Brechungsindex des transparenten Kunststoff des Matrixmaterials der ersten Schicht ab. Je größer die Abweichung ist, desto effizienter ist in der Regel die Strahlablenkung mittels der Streuteilchen.

In einer weiteren bevorzugten Ausgestaltung weisen die Streuteilchen einen Durchschnittsdurchmesser (mittleren Teilchendurchmesser) von wenigstens 0,5 µm, bevorzugt von wenigstens 1 µm bis zu 100 µm oder sogar bis zu 120 µm, mehr bevorzugt von 2 bis 50 µm, am meisten bevorzugt von 2 µm bis 30 µm, auf. Unter "Durchschnittsdurchmesser" (mittlerer Teilchendurchmesser) ist der Zahlendurchschnitt zu verstehen.

Für eine OLED haben sich Durchmesser im obigen Sinn zwischen einschließlich 0,5 µm und einschließlich 50 µm, bevorzugt zwischen einschließlich 2 µm und einschließlich 30 µm als besonders geeignet erwiesen.
Die transparenten, polymeren Streuteilchen sind bevorzugt ein freifließendes Pulver, bevorzugt in kompaktierter Form.

Die Streuteilchen können der Formmasse des transparenten Kunststoff für die Folienmatrix vor der Herstellung der Folie in statistischer Verteilung beigemischt werden.

Als transparente Streuteilchen können Acrylate eingesetzt werden. Diese verfügen bevorzugt über eine ausreichend hohe thermische Stabilität, z.B. bis mindestens 300°C, um bei den Verarbeitungstemperaturen des transparenten Kunststoffs, bevorzugt Polycarbonat, nicht zersetzt zu werden. Bevorzugt werden vernetzte Acrylate als Streuteilchen eingesetzt. Besonders bevorzugt werden Produkte der Linie Techpolymer® der Fa. Sekisui eingesetzt.

Darüber hinaus sollen die Streupigmente über keine Funktionalitäten verfügen, die zu einem Abbau der Polymerkette des Polycarbonat führen. So können z.B. Techpolymer® der Fa. Sekisui oder Paraloid® der Fa. Röhm & Haas gut zur Pigmentierung von transparenten Kunststoffen eingesetzt werden. Aus diesen Produktlinien stehen eine Vielzahl verschiedener Typen zur Verfügung.

In einer weiteren Ausbildungsform der Erfindung können die Streuteilchen Partikel mit einem Kern-Schale-Aufbau umfassen, insbesondere Polymerpartikel mit einer Kern-Schale-Morphologie. Diese Partikel sind vorzugsweise als Vollpartikel und nicht als Hohlpartikel ausgeführt. Die Herstellung von Kern/Mantel-Polymerteilchen ist in EP-A 0 269 324 und in den US-Patenten 3,793,402 und 3,808,180 beschrieben.

Die Streuteilchen können als Voll- oder Hohlpartikel ausgeführt sein, bevorzugt sind die Streuteilchen Vollpartikel.

Hohlpartikel sind z.B. in dem US Patent 5053436 beschrieben. Das Wandmaterial besteht aus Acrylat-Polymer und der Innenraum ist mit Umgebungsluft gefüllt.

Die erste Schicht kann geringe Mengen eines UV-Absorbers enthalten. Die erste Schicht kann 0,01 bis 0,3 Gew.-%, bevorzugt 0,01 bis 0,1 Gew.-% eines UV-Absorbers enthalten. Der UV-Absorber ist bevorzugt ein organischer UV-Absorber und ist beispielsweise ausgewählt aus der Gruppe Benzotriazol-Derivate, Dimere Benzotriazol-Derivate, Triazin-Derivate, Dimere Triazin-Derivate, Diarylcyanoacrylate oder Gemische der vorgenannten Verbindungen. In einer bevorzugten Ausbildung der Erfindung ist der UV-Absorber ein Triazin-Derivat. Bevorzugt enthält die erste Schicht jedoch keinen UV Absorber.

Die erste Schicht enthält bevorzugt außerdem 0,01 bis 4 Gew.-%, besonders bevorzugt 0,05 bis 2 Gew.-% und ganz besonders bevorzugt 0,1 bis 1 Gew.-% eines Anstistatikums, bezogen auf die Gesamtmasse der ersten Schicht. Beispiele für geeignete Antistatika sind kationaktive Verbindungen, beispielsweise quartäre Ammonium-, Phosphonium- oder Sulfoniumsalze, anionaktive Verbindungen, beispielsweise Alkylsulfonate, Alkylsulfate, Alkylphosphate, Carboxylate in Form von Alkali- oder Erdalkalimetallsalzen, nichtionogene Verbindungen, beispielsweise Polyethylenglykolester, Polyethylenglykolether, Fettsäureester, ethoxylierte Fettamine. Bevorzugte Antistatika sind quartäre Ammonium-Verbindungen. In einer besonders bevorzugten Ausbildung der Erfindung ist das Antistatikum Diisopropyldimethyl-ammonium-perfluorbutansulfonat.

Elektrostatisch verursachte Anlagerungen an der Folie, welche sich nachteilig auf die austrittsseitige Strahlungsleistungsverteilung auswirken, können durch den Einsatz dieser Antistatika vermindert werden.

Die erste Schicht weist bevorzugt eine Schichtdicke von 100 bis 300 µm, besonders bevorzugt von 110 bis 160 µm auf.

Bevorzugt weist die Oberfläche der ersten Schicht einen Glanzgrad, bestimmt nach EN ISO 2813 (Winkel 60°) von ≥ 60, besonders bevorzugt ≥ 90 und ganz besonders bevorzugt ≥ 95 auf.

Des Weiteren bevorzugt weist die Oberfläche der ersten Schicht eine Rauhigkeit, bestimmt nach ISO 4288 von ≤ 2 µm, besonders bevorzugt ≤ 1 µm auf.

In einer weiteren, jedoch weniger bevorzugten Ausgestaltung, kann die erste Schicht auch eine strukturierte und matte Oberfläche aufweisen. In diesem Fall ist die matte Oberfläche vorzugsweise mittels der dem Bauelement zugewandten Oberfläche der Kunststofffolie gebildet. Diese Oberfläche weist bevorzugt einen Glanzgrad von ≤ 50 und eine Rauhigkeit von ≥ 15 µm auf.

Die Kunststofffolie umfasst eine zweite Schicht einer Kunststoffzusammensetzung mit den nachstehenden Eigenschaften.

Der Anteil des transparenten Kunststoffs an der Kunststoffzusammensetzung der zweiten Schicht liegt bevorzugt bei 90 bis 99,98 Gew.-%, besonders bevorzugt bei 92,5 bis 99,98 Gew.-%, und ganz besonders bevorzugt bei 95 bis 99,98 Gew.-%, bezogen auf die Gesamtmasse der zweiten Schicht.

Erfindungsgemäß ist der transparente Kunststoff der zweiten Schicht ein Polyacrylat oder Polymethacrylat, besonders bevorzugt ein Polymethacrylat und ganz besonders bevorzugt ein Polyalkylmethacrylat mit Alkylkettenlängen unter 10 Kohlenstoffatomen (-CₙH₂ₙ₊₁ mit n < 10). Insbesondere bevorzugt ist Polymethyl(meth)acrylat (PMMA, n = 1).

Als Polymethacrylat können sowohl Polymethyl(meth)acrylat (PMMA) als auch Blends aus PMMA oder aus schlagzähem PMMA eingesetzt werden. Sie sind unter der Marke Plexiglas® bei der Röhm GmbH erhältlich. Unter Polymethyl(meth)acrylat werden sowohl Polymere der Methacrylsäure und ihrer Derivate, beispielsweise ihrer Ester, als auch Polymere der Acrylsäure und ihrer Derivate als auch Mischungen aus beiden vorstehenden Komponenten verstanden.

Bevorzugt sind Polymethyl(meth)acrylat-Kunststoffe mit einem Methylmethacrylat-Monomeranteil von mindestens 80 Gew.-%, bevorzugt mindestens 90 Gew.-% und gegebenenfalls 0 Gew.-% bis 20 Gew.-%, bevorzugt 0 Gew.-% bis 10 Gew.-% zweiter vinylisch copolymerisierbarer Monomere wie z. B. C₁- bis C₈-Alkylestern der Acrylsäure oder der Methacrylsäure, z. B. Methylacrylat, Ethylacrylat, Butylacrylat, Butylmethacrylat, Hexylmethacrylat, Cyclohexylmethacrylat, ferner Styrol und Styrolderivate, wie beispielsweise [alpha]-Methylstyrol oder p-Methylstyrol. Zweite Monomere können sein Acrylsäure, Methacrylsäure, Maleinsäureanhydrid, Hydroxyester der Acrylsäure oder Hydroxyester der Methacrylsäure.

Die zweite Schicht weist bevorzugt eine Schichtdicke von 15 bis 60 µm, besonders bevorzugt von 30 bis 50 µm auf.

Die zweite Schicht enthält 0,01 bis 10 Gew.-%, bevorzugt 0,01 bis 7,5 Gew.-% und besonders bevorzugt 0,01 bis 5 Gew.-% eines UV-Absorbers. Der UV-Absorber ist bevorzugt ein organischer UV-Absorber und ist beispielsweise ausgewählt aus der Gruppe Benzotriazol-Derivate, Dimere Benzotriazol-Derivate, Triazin-Derivate, Dimere Triazin-Derivate, Diarylcyanoacrylate oder Gemische der vorgenannten Verbindungen. In einer bevorzugten Ausbildung der Erfindung ist der UV-Absorber ein Triazin-Derivat, besonders bevorzugt ein Triazin der allgemeinen Formel (I). 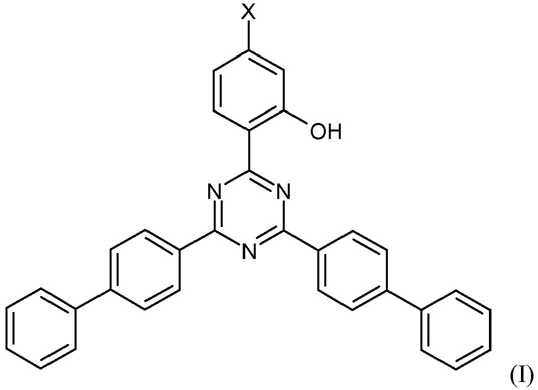 wobei X = OR¹; OCH₂CH₂OR¹; OCH₂CH(OH)CH₂OR¹ oder OCH(R²)COOR³ bedeutet, dabei steht, R¹ für jeweils verzweigtes oder unverzweigtes C₁-C₁₃-Alkyl, C₂-C₂₀-Alkenyl, C₆-C₁₂-Aryl oder -CO-C₁-C₁₈-Alkyl, R² ist H oder verzweigtes oder unverzweigtes C₁-C₈-Alkyl, und R³ C₁-C₁₂-Alkyl; C₂-C₁₂-Alkenyl oder C₅-C₆-Cycloalkyl bedeutet.

In einer besonders bevorzugten Ausbildung der erfindungsgemäßen zweiten Schicht, ist X = OR¹, wobei R¹ die oben genannte Bedeutung hat, ganz besonders bevorzugt ist X = OR¹, wobei R¹ = CH₂CH(CH₂CH₃)C₄H₉.

Solche biphenylsubstituierten Triazine der allgemeinen Formel I sind aus WO 96/28431; DE 197 39 797; WO 00/66675; US 6225384; US 6255483; EP 1 308 084 und FR 2812299 prinzipiell bekannt.

Die zweite Schicht enthält bevorzugt 0,01 bis 4,0 Gew.-%, besonders bevorzugt 0,05 bis 2,0 Gew.-% und ganz besonders bevorzugt 0,1 bis 1,0 Gew.-% eines Anstistatikums, bezogen auf die Gesamtmasse der zweiten Schicht. Das Antistatikum ist beispielsweise ausgewählt aus den für die erste Schicht angeführten Verbindungen. In einer bevorzugten Ausbildung der Erfindung ist das Antistatikum Diisopropyldimethylammoniumperfluorbutansulfonat.

Bevorzugt weist die Oberfläche der zweiten Schicht einen Glanzgrad, bestimmt nach EN ISO 2813 (Winkel 60°) von ≥ 60, besonders bevorzugt ≥ 90 und ganz besonders bevorzugt ≥ 95 auf.

Des Weiteren bevorzugt weist die Oberfläche der zweiten Schicht eine Rauhigkeit, bestimmt nach ISO 4288 von ≤ 2 µm, besonders bevorzugt ≤ 1 µm auf.

Der Glanzgrad der Folienoberfläche ist besonders wichtig und beeinflusst die optischen Eigenschaften der Folie. Insbesondere kann hierüber der optische Eindruck des nichtbetriebenen Bauelements eingestellt werden.

In einer speziellen Ausführungsform der Kunststofffolie kann die zweite Schicht ein Coating aufweisen. Das Coating ist bevorzugt ein dem Fachmann bekannter Hard-Coat. Besonders bevorzugt basiert der Hard-Coat auf einem vernetzten transparenten Kunststoff. Durch das Coating erhält die Oberfläche der Kunststofffolie bevorzugt eine Pencil Hardness (bestimmt nach ISO 15184) von ≥ 1H und < 8H und besonders bevorzugt von ≥ 2H und ≤ 5H. Das Coating kann direkt ohne Primerung auf die zweite Schicht aufgebracht werden. Das Coating kann auch einen UV-Absorber enthalten, der den zuvor für UV-Absorber genannten bevorzugten Ausführungsformen entspricht.

Sowohl die erste Schicht, als auch die zweite Schicht der Kunststofffolie können zusätzlich Additive, wie beispielsweise Verarbeitungshilfsmittel enthalten. Dies umfasst insbesondere Entformungsmittel, Fließmittel, Stabilisatoren, insbesondere Thermostabilisatoren und/oder optische Aufheller. In jeder Schicht können dabei unterschiedliche Additive bzw. unterschiedliche Konzentrationen von Additiven vorhanden sein. Vorzugsweise enthält die zweite Schichten die Entformungsmittel.

Bevorzugt werden die für Polycarbonate geeigneten Stabilisatoren eingesetzt. Geeignete Stabilisatoren sind beispielsweise Phosphine, Phosphite oder Si enthaltende Stabilisatoren und weitere in EP-A 0 500 496 beschriebene Verbindungen. Beispielhaft seien Triphenylphosphite, Diphenylalkylphosphite, Phenyldialkylphosphite, Tris-(nonylphenyl)phosphit, Tetrakis-(2,4-di-tert.-butylphenyl)-4,4'-biphenylen-diphosphonit, Bis(2,4-dicumylphe-nyl)petaerythritoldiphosphit und Triarylphosphit genannt. Besonders bevorzugt sind Triphenylphosphin und Tris-(2,4-di-tert.-butylphenyl)phosphit.

Geeignete Entformungsmittel sind beispielsweise die Ester oder Teilester von ein- bis sechswertigen Alkoholen, insbesondere des Glycerins, des Pentaerythrits oder von Guerbetalkoholen.

Einwertige Alkohole sind beispielsweise Stearylalkohol, Palmitylalkohol und Guerbetalkohole, ein zweiwertiger Alkohol ist beispielsweise Glycol, ein dreiwertiger Alkohol ist beispielsweise Glycerin, vierwertige Alkohole sind beispielsweise Pentaerythrit und Mesoerythrit, fünfwertige Alkohole sind beispielsweise Arabit, Ribit und Xylit, sechswertige Alkohole sind beispielsweise Mannit, Glucit (Sorbit) und Dulcit.

Die Ester sind bevorzugt die Monoester, Diester, Triester, Tetraester, Pentaester und Hexaester oder deren Mischungen, insbesondere statistische Mischungen, aus gesättigten, aliphatischen C₁₀ bis C₃₆-Monocarbonsäuren und gegebenenfalls Hydroxy-Monocarbonsäuren, vorzugsweise mit gesättigten, aliphatischen C₁₄ bis C₃₂-Monocarbonsäuren und gegebenenfalls Hydroxy-Monocarbonsäuren.

Die kommerziell erhältlichen Fettsäureester, insbesondere des Pentaerythrits und des Glycerins, können herstellungsbedingt weniger als 60 % unterschiedlicher Teilester enthalten.

Gesättigte, aliphatische Monocarbonsäuren mit 10 bis 36 C-Atomen sind beispielsweise Caprinsäure, Laurinsäure, Myristinsäure, Palmitinsäure, Stearinsäure, Hydroxystearinsäure, Arachinsäure, Behensäure, Lignocerinsäure, Cerotinsäure und Montansäuren.

Die Kunststofffolie kann auch organische Farbstoffe, anorganische Farbpigmente, Fluoreszenzfarbstoffe und besonders bevorzugt optische Aufheller enthalten.

Sowohl die erste Schicht, als auch die zweite Schicht der Kunststofffolie können zusätzlich auch Wellenlängenkonversionsstoffe enthalten. Als Wellenlängenkonversionsstoffe werden Materialien bezeichnet, die geeignet sind, elektromagnetische Primärstrahlung zumindest teilweise zu absorbieren und als Sekundärstrahlung mit einem zumindest teilweise von der Primärstrahlung verschiedenen Wellenlängenbereich zu emittieren. Die elektromagnetische Primärstrahlung und elektromagnetische Sekundärstrahlung können eine oder mehrere Wellenlängen und/oder Wellenlängenbereiche in einem infraroten bis ultravioletten Wellenlängenbereich umfassen, insbesondere in einem sichtbaren Wellenlängenbereich. Dabei kann das Spektrum der Primärstrahlung und/oder das Spektrum der Sekundärstrahlung schmalbandig sein, das heißt, dass die Primärstrahlung und/oder die Sekundärstrahlung einen einfarbigenoder annähernd einfarbigen Wellenlängenbereich aufweisen können. Das Spektrum der Primärstrahlung und/oder das Spektrum der Sekundärstrahlung kann alternativ auch breitbandig sein, das heißt, dass die Primärstrahlung und/oder die Sekundärstrahlung einen mischfarbigen Wellenlängenbereich aufweisen kann, wobei der mischfarbige Wellenlängenbereich ein kontinuierliches Spektrum oder mehrere diskrete spektrale Komponenten mit verschiedenen Wellenlängen aufweisen kann. Beispielsweise kann die elektromagnetische Primärstrahlung einen Wellenlängenbereich aus einem ultravioletten bis blauen Wellenlängenbereich aufweisen, während die elektromagnetische Sekundärstrahlung einen Wellenlängenbereich aus einem blauen bis roten Wellenlängenbereich aufweisen kann. Besonders bevorzugt können die Primärstrahlung und die Sekundärstrahlung überlagert einen weißfarbigen Leuchteindruck erwecken. Dazu kann die Primärstrahlung vorzugsweise einen blaufarbigen Leuchteindruck erwecken und die Sekundärstrahlung einen gelbfarbigen Leuchteindruck, der durch spektrale Komponenten der Sekundärstrahlung im gelben Wellenlängenbereich und/oder spektrale Komponenten im grünen und roten Wellenlängenbereich entstehen kann.

Der Wellenlängenkonversionsstoff kann dabei eines oder mehrere der folgenden Materialien aufweisen: Granate der Seltenen Erden und der Erdalkalimetalle, beispielsweise YAG:Ce³⁺, weiterhin auch Nitride, Nitridosilikate, Sione, Sialone, Aluminate, Oxide, Halophosphate, Orthosilikate, Sulfide, Vanadate, Perylene, Coumarin und Chlorosilikate.

Weiterhin kann die Wellenlängenkonversionsschicht auch geeignete Mischungen und/oder Kombinationen umfassen, die beispielsweise die genannten Wellenlängenkonversionsstoffe aufweisen. Dadurch kann es beispielsweise möglich sein, dass wie oben beschrieben, die Wellenlängenkonversionsschicht in einem blauen ersten Wellenlängenbereich absorbiert und in einem zweiten Wellenlängenbereich emittiert, der grüne und rote Wellenlängen und/oder gelbe Wellenlängenbereiche aufweist.

Die Kunststofffolie weist bevorzugt eine Gesamtdicke von 120 bis 400 µm, bevorzugt von 200 µm auf.

Als Folie ist im Zweifel eine Schicht oder ein Schichtverbund anzusehen, die bzw. der das Eigengewicht nicht trägt, also nicht freitragend ausgebildet ist, und insbesondere flexibel ist.

Zur Herstellung der Kunststofffolie können die erste und die zweite Schicht, durch Coextrusion oder durch das Verbinden separater vorgefertigter Folien durch beispielsweise Kaschieren oder Laminieren zusammengeführt werden. In einer bevorzugten Ausführungsform der Erfindung sind die erste und die zweite Schicht coextrudiert ausgeführt.

Zur Herstellung der Kunststofffolie durch Extrusion wird das Kunststoffgranulat, beispielsweise das Polycarbonatgranulat bevorzugt einem Fülltrichter eines Extruders zugeführt und gelangt über diesen in das Plastifiziersystem bestehend aus Schnecke und Zylinder. Im Plastifiziersystem kann das Fördern und Aufschmelzen des Kunststoffmaterials erfolgen. Die Kunststoffschmelze wird bevorzugt durch eine Breitschlitzdüse gedrückt. Zwischen Plastifiziersystem und Breitschlitzdüse können eine Filtereinrichtung, eine Schmelzpumpe, stationäre Mischelemente und weitere Bauteile angeordnet sein. Die die Düse verlassende Schmelze gelangt bevorzugt auf einen Glättkalander. Eine glatte und/oder glänzende Oberfläche wird vorzugsweise mit polierten Metallwalzen hergestellt. Zur einseitigen Strukturierung der Folienoberfläche der ersten Schicht kann gegebenenfalls eine Gummi-Walze eingesetzt werden. Im Walzenspalt des Glättkalanders kann die endgültige Formgebung erfolgen. Die für die Strukturierung der Folienoberfläche vorzugsweise verwendeten Gummi-Walzen werden in US 4 368 240 beschrieben. Die Formfixierung kann letztendlich durch Abkühlung und zwar wechselseitig auf den Glättwalzen und an der Umgebungsluft erfolgen. Die weiteren Einrichtungen des Plastifizierungssystems dienen gegebenenfalls dem Transport, dem eventuell gewünschten Aufbringen von Schutzfolien und dem Aufwickeln der extrudierten Folien.

Durch Einsatz von einem oder mehrerer Seitenextruder und geeigneten Schmelzeadaptern vor der Breitschlitzdüse lassen sich Polymerschmelzen verschiedener Zusammensetzung übereinander legen und somit mehrschichtige Folien erzeugen (siehe beispielsweise EP-A 0 110 221 und EP-A 0 110 238).

Die Herstellung der zweiten und gegebenenfalls auch der dritten Schicht erfolgt vorzugsweise über die Herstellung eines Compounds (a) aus (a1) dem zweiten transparenten Kunststoff und (a2) einem UV Absorber, bevorzugt einem biphenylsubstituierten Triazin der allgemeinen Formel (I). Anschließend kann das Compound (a) entweder (i) mit dem ersten transparenten Kunststoff in der Weise coextrudiert werden, dass sich eine dünne UV-Schutzschicht aus Compound (a) gut haftend auf der Oberfläche des ersten transparenten Kunststoff befindet, oder (ii) das Compound (a) kann zu einer dünnen Folie weiterverarbeitet werden, die anschließend mit einer Folie des ersten transparenten Kunststoff zu einem gut haftenden Verbund hinterspritzt oder laminiert wird. In einer alternativen Ausführungsvariante kann die zweite und gegebenenfalls auch dritte Schicht auf die erste Schicht bzw. gegebenenfalls zweite Schicht auflackiert werden.

Ein weiterer Gegenstand der Erfindung ist die Verwendung der Kunststofffolie als optische Auskopplungsfolie, insbesondere als optische Streu- oder Auskopplungsfolie in organischen lichtemittierenden Dioden (OLED).

Gegenstand der Erfindung ist ein organisches strahlungsemittierendes Bauelement mit einer zur Strahlungserzeugung ausgebildeten aktiven organischen Schicht und einer oder zwei Strahlungsauskoppelseiten, dadurch gekennzeichnet, dass auf der oder den Strahlungsauskoppelseiten des Bauelements eine Kunststofffolie angeordnet ist.

In einer bevorzugten Ausführungsform der Erfindung umfasst das erfindungsgemäße Bauelement ein Substrat, auf dem die organische Schicht angeordnet ist. Die Kunststofffolie kann dabei auf der von der organischen Schicht abgewandten Seite des Substrats, auf derselben Seite auf der auch die organische Schicht aufgebracht ist oder auch auf beiden Seiten angeordnet sein. Bevorzugt ist die Kunststofffolie mit dem Substrat verbunden. Ebenfalls bevorzugt ist die erste Schicht der Kunststofffolie dem Substrat zugewandt und die zweite Schicht dem Substrat abgewandt angeordnet.

Ein weiterer Gegenstand der Erfindung ist die Verwendung des erfindungsgemäßen Bauelements als organische lichtemittierende Diode (OLED).

Die aktive Schicht ist hierbei zweckmäßigerweise mittels einer organischen Schicht gebildet, die ein organisches (halb)leitendes Material enthält. Die organische Schicht enthält dabei zum Beispiel zumindest ein (halb)leitendes Polymer und/oder umfasst zumindest eine Schicht mit einem (halb)leitenden Molekül, insbesondere einem niedermolekularen Molekül.

Eine vorgefertigte OLED kann insbesondere Elektroden für die elektrische Kontaktierung und, alternativ oder zusätzlich, eine die organische Schicht schützende Verkapselung, welche die organische Schicht beispielsweise vor Feuchtigkeit schützt, umfassen.

In einer vorteilhaften Ausgestaltung umfasst das Bauelement ein Substrat, auf dem die aktive organische Schicht angeordnet ist. Zweckmäßigerweise stabilisiert das Substrat die aktive Schicht mechanisch.

Das Substrat kann insbesondere durch eine Schicht gebildet sein, auf der die organische Schicht und gegebenenfalls Elektroden zur elektrischen Kontaktierung und/oder weitere Elemente des Bauelements aufgebracht sind.

Die Kunststofffolie ist bevorzugt mit dem Substrat verbunden. Aufgrund der gegenüber einer Folie in der Regel hohen mechanischen Stabilität des Substrats kann die Kunststofffolie an dem Substrat besonders einfach stabil und vorzugsweise dauerhaft befestigt werden. Zweckmäßigerweise ist das Substrat freitragend ausgebildet.
Alternativ kann das Substrat flexibel ausgebildet sein. Für eine flexible Ausbildung eignet sich zum Beispiel eine Folie, insbesondere eine Folie aus Kunststoff, z.B. eine PMMA-Folie. Durch die Kunststofffolie kann die mechanische Stabilität des Substrat/Kunststofffolien-Verbunds gegenüber einem flexiblen Substrat, das nicht mit einer Kunststofffolie versehen ist, erhöht werden.

Beispielsweise kann das Substrat Glas, Quarz, Metall, Metallfolien, Folien aus Kunststoff, Halbleiterwafer wie etwa Siliziumwafer oder eine Germaniumwafer oder Wafer basierend auf Phosphor- und/oder Stickstoff-haltigen Halbleitermaterialien oder ein beliebiges anderes geeignetes Substratmaterial umfassen.

In einer bevorzugten Ausführungsform des erfindungsgemäßen Bauelements ist das Substrat für die in der aktiven Schicht erzeugte Strahlung durchlässig, also insbesondere aus einem strahlungsdurchlässigen Material gebildet. Die von der aktiven Schicht abgewandte Seite des Substrats kann so eine Strahlungsaustrittsfläche des Bauelements bilden. Beispielsweise enthält das Substrat ein Glas. Ein Glassubstrat wird insbesondere bei OLEDs häufig eingesetzt.
Das Substrat kann ferner elektrisch isolierend ausgebildet sein. Die elektrische Kontaktierung des Bauelements erfolgt in diesem Falle vorzugsweise auf der der Kunststofffolie abgewandten Seite des Substrats.

Das Substrat kann weiterhin im Wesentlichen vollflächig mit der Kunststofffolie versehen sein. Bevorzugt überdeckt die Kunststofffolie zumindest die aktive organische Schicht vollständig.

In einer weiteren bevorzugten Ausgestaltung ist die erste Schicht der Kunststofffolie an das Bauelement brechungsindexangepasst. Der Strahlungsübertritt von Strahlung aus dem Bauelement in die Kunststofffolie wird so erleichtert und die Reflexionsverluste an Grenzfläche(n) zwischen Bauelement und Kunststofffolie werden gemindert. Für die Brechungsindexanpassung weicht der Brechungsindex der ersten Schicht bzw. für den Fall, dass Streuteilchen eingebaut sind, derjenige des transparenten Kunststoff der ersten Schicht bevorzugt um 20 % oder weniger, besonders bevorzugt um 10 % oder weniger von dem Brechungsindex des seitens des Bauelements angeordneten Materials, insbesondere dem Brechungsindex des Substrats ab.

Für die Brechungsindexanpassung kann ein entsprechend geeignetes Material für die erste Schicht der Kunststofffolie eingesetzt werden. Zur Brechungsindexanpassung an ein Glassubstrat ist beispielsweise ein Polycarbonat besonders geeignet.

Alternativ oder ergänzend kann ein Brechungsindexanpassungsmaterial, z.B. ein optisches Gel für die Brechungsindexanpassung, eingesetzt werden, das zwischen der ersten Schicht der Kunststofffolie und dem Substrat angeordnet ist. Mit Vorzug mindert das Brechungsindexanpassungsmaterial den Brechungsindexsprung vom Substrat zur ersten Schicht der Kunststofffolie.

In einer weiteren vorteilhaften Ausgestaltung ist die Kunststofffolie an dem Bauelement befestigt. Bevorzugt ist die Kunststofffolie mittels eines Haftvermittlers an dem Bauelement, insbesondere dem Substrat, befestigt oder die Kunststofffolie ist auf das Bauelement, insbesondere auf das Substrat, auflaminiert. Wird ein Haftvermittler eingesetzt, so kann dieser mit Vorteil zugleich als Brechungsindexanpassungsmaterial dienen.

In einer weiteren bevorzugten Ausgestaltung ist das Verbundsubstrat, das die Kunststofffolie und das Substrat umfasst, aufgrund der Kunststofffolie derart mechanisch stabilisiert, dass das Verbundsubstrat selbst bei einer Beschädigung des Substrats mechanisch durch die Kunststofffolie stabilisiert wird.
Dies ist besonders zweckmäßig falls das Substrat aus einem splitterfähigen Material, zum Beispiel Glas, gebildet ist. Ein gesplittertes Substrat kann mittels der Kunststofffolie zusammengehalten werden. Die Kunststofffolie ist hierzu zweckmäßigerweise mit einer geeigneten mechanischen Stabilität ausgebildet und mechanisch stabil und vorzugsweise dauerhaft mit dem Substrat verbunden.

Über die Kunststofffolie kann so die Gesamtstabilität des Verbundsubstrats und darüber die des Verbundbauelements vorteilhaft erhöht werden. Weiterhin wird die Gefahr von durch Splitter hervorgerufenen Verletzungen bei der Handhabung des Bauelements verringert.

In einer weiteren vorteilhaften Ausgestaltung ist das Bauelement zur Beleuchtung, insbesondere zur Allgemeinbeleuchtung vorgesehen. Das Bauelement kann beispielsweise zur Innenraumbeleuchtung, zur Außenraumbeleuchtung oder in einer Signalleuchte eingesetzt werden.

Das Bauelement ist, insbesondere für den Einsatz in der Allgemeinbeleuchtung, bevorzugt zur Erzeugung sichtbarer Strahlung ausgebildet. Über die Kunststofffolie kann die auskoppelseitige Leuchtdichte erheblich gesteigert werden.

Die Erfindung wird durch die folgenden Beispiele weiter erläutert ohne auf diese beschränkt zu sein. Die erfindungsgemäßen Beispiele geben lediglich bevorzugte Ausführungsformen der vorliegenden Erfindung wieder.

### Beispiele:

### Verwendete Substanzen:

Makrolon 2600 000000:
   Mittelviskoses Hochviskoses Bisphenol A Polycarbonat mit einem MVR von 12,5 cm³/10min (nach ISO 1133 bei 300 °C und 1,2 kg)
Tinuvin 1600:
   UV-Schutzmittel der Firma Ciba Specialty Chemicals (biphenylsubstituiertes Triazin der Formel I mit X = OCH₂CH(CH₂CH₃)C₄H₉)
Plexiglas 8N:
   PMMA mit einem MVR von 3 cm³/10min (nach ISO 1133 bei 230°C und 3,8 kg) und einem Gewichtsmittleren Molekulargewicht M_{w} von 124 kg/mol (bestimmt durch Gelpermeationschromatographie bei 23 °C in Tetrahydrofuran; Kalibrierung auf Polystyrolstandards der Firma Röhm GmbH & Co. KG.

### Beispiel 1:

### Herstellung eines Streu-Master-Batches durch Compoundierung:

Die Herstellung des Master-Batches erfolgt mit herkömmlichen Zweischnecken-Compoundierextrudern (z.B. ZSK 32) bei für Polycarbonat üblichen Verarbeitungstemperaturen von 250 bis 330 °C.

Es wurde ein Master-Batch mit folgender Zusammensetzung hergestellt:
- 80 Gew.-% Makrolon® 2600 000000 (Polycarbonat (PC) der Fa.
   Bayer MaterialScience AG)
- 20 Gew.-% Vernetzte kugelförmige Methylmethacrylat-Partikel (Techpolymer® BMSA-18GN der Fa. Sekisui) mit einer Teilchengröße von 0,5 bis 5 µm und einer mittleren Teilchengröße von ca. 2 µm.

### Beispiel 2:

### Herstellung des Tinuvin 1600-UV-Schutz-Compounds:

Die Herstellung des Tinuvin 1600-UV-Schutz-Compounds (Granulat) erfolgte mit einem herkömmlichen Zweischnecken-Compoundierextruder bei für Polymethylmethacrylat üblichen Verarbeitungstemperaturen von 230 bis 285 °C.

Es wurde ein Master-Batch mit folgender Zusammensetzung hergestellt:
- Plexiglas 8N der Fa. Evonik mit einem Anteil von 95 Gew.-%
- Tinuvin 1600 als farbloses Pulver mit einem Anteil von 5 Gew-%.

Zu 85 kg Plexiglas 8N_wurden auf einem Zweischneckenextruder (ZSK 32) bei einer Drehzahl von 190 min⁻¹ und einem Durchsatz von 50 kg/h 15 kg Pulver-Compound, bestehend aus 10 kg Plexiglas 8N-Grieß (Mittlerer Partikel-Durchmesser ca. 0,8 mm) und 5 kg Tinuvin 1600, entspricht 5 Gew.-%) zudosiert. Die Massentemperatur betrug 278 °C und das erhaltene Granulat war klar und transparent.

### Beispiel 3 bis 6:

### Herstellung einer coextrudierten Folie:

### Folien-Coextrusion

Die verwendete Anlage besteht aus
- einem Extruder mit einer Schnecke von 105 mm Durchmesser (D) und einer Länge von 41xD. Die Schnecke weist eine Entgasungszone auf;
- einen Coextruder zum Aufbringen der Deckschicht mit einer Schnecke der Länge 41 D und einem Durchmesser von 35 mm
- einem Umlenkkopf;
- eine speziellen Coextrusions-Breitschlitzdüse mit 1500 mm Breite;
- einem Dreiwalzen-Glättkalander mit horizontaler Walzenanordnung, wobei die dritte Walze um +/- 45° gegenüber der Horizontalen schwenkbar ist;
- einer Rollenbahn;
- einer Einrichtung zum beidseitigen Aufbringen von Schutzfolie;
- einer Abzugseinrichtung;
- Aufwickelstation.

Das Granulat des Basismaterials wurde dem Fülltrichter des Hauptextruders zugeführt. Im jeweiligen Plastifiziersystem Zylinder/Schnecke erfolgte das Aufschmelzen und Fördern des jeweiligen Materials. Beide Materialschmelzen wurden in der Coextrusionsdüse zusammengeführt. Von der Düse gelangt die Schmelze auf den Glättkalander, dessen Walzen die in der Tabelle 1 genannte Temperatur aufweisen. Auf dem Glättkalander erfolgt die endgültige Formgebung und Abkühlung des Materials. Zur Glättung der Oberflächen wurden polierte Chrom-Walzen eingesetzt. Anschließend wird die Folie durch einen Abzug transportiert, es wird die Schutzfolie beidseitig aufgebracht, danach erfolgt die Aufwicklung der Folie.

Es wurden folgende Verfahrensparameter gewählt:

**Tabelle 1**

| | |
|---|---|
| Temperatur des Hauptextruders | 295 °C +/- 5°C |
| Temperatur des Coextruders | 270 °C +/-5°C |
| Temperatur des Umlenkkopfes | 285 °C +/-5°C |
| Temperatur der Düse | 300 °C +/-5°C |
| Drehzahl des Hauptextruders | 60 min⁻¹ |
| Drehzahl des Coextruders | 31 min⁻¹ |
| Temperatur der Walze 1 | 76 °C |
| Temperatur der Walze 2 | 73 °C |
| Temperatur der Walze 3 | 140 °C |
| Abzugsgeschwindigkeit | 14,6 m/min |

### Hauptextruder:

Es wurde ein Compound folgender Zusammensetzung abgemischt:
- Streu-Masterbatch aus Beispiel 1 und Polycarbonat Makrolon 2600 000000 der Fa. Bayer MaterialScience AG mit einem Anteil gemäß den Spalte 2 "Hauptextruder" in der Tabelle 2

### Coextruder:

Es wurde ein Compound (Coextruder) folgender Zusammensetzung abgemischt:
- 37,5 Gew.-% Tinuvin 1600-UV-Schutz -Masterbatch und 62,5 Gew.-% Plexiglas (PMMA) 8N der Fa. Evonik

Es wurde eine Folie, die beidseitig einen Glanzgrad, bestimmt nach EN ISO 2813 (Winkel 60°) von > 95 und eine Rauhigkeit, bestimmt nach ISO 4288 von < 0,5 µm aufweist extrudiert. Die Folie wies eine Gesamtschichtdicke von 200µm auf, wobei die Dicke der Basisschicht 160 µm und die der Coextrusionsschicht 40 µm betrug.

Die Dicke der so erhaltenen transparenten Beschichtung wurde mittels eines Eta SD 30 der Firma Eta Optik GmbH bestimmt.

**Tabelle 2**

| | Hauptextruder | Co extruder |
|---|---|---|
| Beispiel 3 | 160µm 20% Compound aus Beispiel 1 + 80% M.2600 | 40µm 37,5% Compound (Coextruder) + 62,5% PMMA 8N |
| Beispiel 4 | 160µm 30% Compound aus Beispiel 1 + 70% M.2600 | 40µm 37,5% Compound (Coextruder) + 62,5% PMMA 8N |
| Beispiel 5 | 160µm 37,5% Compound aus Beispiel 1 + 62,5% M.2600 | 40µm 37,5% Compound (Coextruder) + 62,5% PMMA 8N |
| Beispiel 6 | 160µm 50% Compound aus Beispiel 1 + 50% M.2600 | 40µm 37,5% Compound (Coextruder) + 62,5% PMMA 8N |

### Beispiel 7 (nicht erfindungsgemäßes Vergleichsbeispiel):

Es wurde ein Compound folgender Zusammensetzung abgemischt:
50 Gew.-% Streu-Masterbatch aus Beispiel 1 und 50 Gew.-% Polycarbonat Makrolon 2600 000000 der Fa. Bayer MaterialScience AG

Hieraus wurde eine 100 µm dicke Folie extrudiert, die beidseitig glatt ist und einen Glanzgrad, bestimmt nach EN ISO 2813 (Winkel 60°) von > 95 und eine Rauhigkeit, bestimmt nach ISO 4288 von < 0,5 µm aufweist.

### Beispiel 8: Anwendungstechnischen Untersuchungen

### Aufbau der Test-OLED:

Als Test-OLED wurde eine zweifach gestapelte, als "Bottom Emitter" ausgeführte OLED mit Aluminium-Kathode und einer Leuchtfläche von 1,68 cm² eingesetzt, die mit 2,5 mA/cm² bestromt wurde (dabei betrug die gemessene Spannung 5,7 V).

Auf die Test-OLED wurden die Folien gemäß der Beispiele 3 bis 7 mit Hilfe eines Haftvermittlers aufgeklebt. Dazu wurde der Liner von einem Haftvermittler (OCA 8212 der Firma 3M) abgezogen und der Haftvermittler an die Folie angelegt. Die Seite, auf der der Liner abgezogen wurde, zeigte zur ersten Schicht der Folie, die Polycarbonat enthielt. Der Haftvermittler wurde mit einer Handwalze auf die Folie auflaminiert. Eine entsprechend große Probe wurde aus der Folie zugeschnitten und der Liner auf der von der Folie abgewandten Seite des Haftvermittlers abgezogen. Der Folie-Haftvermittler-Verbund wurde mit der freigelegten Haftvermittlerseite zum OLED-Substrat hin ausgerichtet, angelegt und mit einer Handwalze auf die OLED auflaminiert.

### Bestimmung der optischen Größen (Tabelle 3):

**Peff [lm/W]:** Effizienz des OLED Lichtstroms einer Test-OLED (aktive Fläche 1.68 cm² betrieben bei einer Stromdichte von 2.00 m/A*cm²). Der Lichtstrom der OLED [photometrisch gewichtet **→** in lm] wurde in einer Ulbrichtkugel bestimmt, die über eine Glasfaser mit einem Spektrometer verbunden war. Der Gleichstrom wurde mit einem hochgenauen Labornetzteil vorgegeben und die anliegende Spannung mit demselben Gerät gemessen. Das Produkt aus Strom und Spannung ergibt die benötigte elektrische Leistung.

**Ratio 1:** Effizienzverhältnis zur Referenz-OLED ohne Folie.

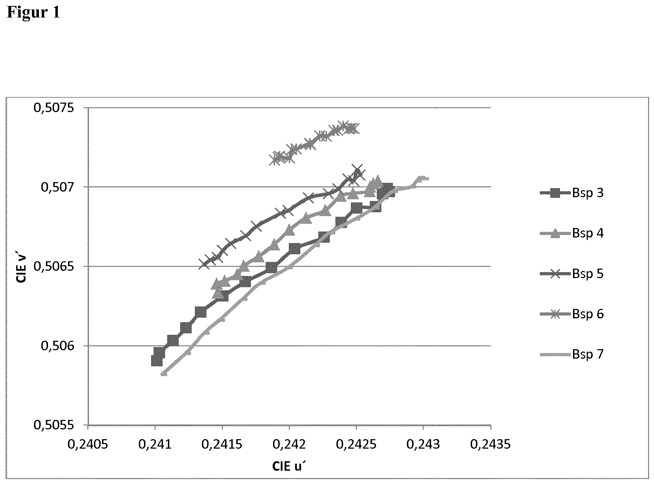

**Delta_C:** Die Messung der winkelabhängigen OLED-Emission erfolgte mittels eines Goniometers mit Glasfaserspektrometer. Der winkelabhängig erfassten Emission entsprechen Farbkoordinaten (im u' v' - Raum). Die Transformation der bestimmten Farbwerte in u' v' Koordinaten erfolgte nach der DIN EN ISO 11664-5 (Gleichung (4)).
Die Farbkoordinaten wurden in einem Winkelbereich von 0° bis 75° zur Bauteilnormalen bestimmt. Diese Farbkoordinaten wurden innerhalb von 30°-Segmenten betrachtet. Die erste Betrachtung erfolgte innerhalb von 70°- 40°, die letzte Betrachtung erfolgte von 30°-0°. Für jedes 30°- Segment wurde der maximale Farbabstand zwischen zwei Farbkoordinatenpaaren bestimmt (die Messungen bei zwei verschiedenen Winkeln entsprechen). Der maximale Farbabstand (in u' v' Koordinaten) der bei der Betrachtung aller Segmente festgestellt wurde, ist Delta_C.
Die Ergebnisse der winkelabhängigen Messungen sind in Figur 1 dargestellt.

**Tabelle 3**

| | Daten aus Ulbrichtkugel | | |
|---|---|---|---|
| | Peff [lm/W] | Ratio 1 | Delta C |
| ohne Folie | 26,00 | 1,00 | 0,0231 |
| Bsp. 3 | 33,20 | 1,28 | 0,0012 |
| Bsp. 4 | 33,10 | 1,27 | 0,0009 |
| Bsp. 5 | 32,70 | 1,26 | 0,0008 |
| Bsp.6 | 31,90 | 1,23 | 0,0003 |
| Bsp. 7 | 32,00 | 1,23 | 0,0012 |

Aus Tabelle 3 ist ersichtlich, dass die mit den erfindungsgemäßen Folien 3 bis 6 ausgestatteten OLEDs eine hohe Effizienz und die Filmen 3 bis 5 sogar eine deutlich verbesserte Effizienz gegenüber der Vergleichsfolie 7 aufweisen. Figur 1 zeigt, dass die mit den erfindungsgemäßen Folien 3 bis 6 ausgestatteten OLEDs einen konstanten, Farbeindruck zeigen, der weitestgehend unabhängig vom Betrachterwinkel ist. Durch die Folien 4 bis 6 lässt sich eine deutliche Verbesserung des Farbeindrucks gegenüber der Vergleichsfolie 7 erzielen.

## Patentansprüche

1. Organisches strahlungsemittierendes Bauelement mit einer zur Strahlungserzeugung ausgebildeten organischen Schicht und einer oder zwei Strahlungsauskoppelseiten, **dadurch gekennzeichnet, dass** auf der oder den Strahlungsauskoppelseiten des Bauelements eine Kunststofffolie angeordnet ist, welche die Merkmale aufweist:
die Kunststofffolie umfasst mindestens eine erste Schicht einer Kunststoffzusammensetzung enthaltend einen ersten transparenten Kunststoff, sowie 5 bis 9 Gew.-% transparenter, polymerer Streuteilchen, bezogen auf die Gesamtmasse der ersten Schicht, und mindestens eine zweite Schicht einer Kunststoffzusammensetzung enthaltend einen zweiten transparenten Kunststoff und 0,01 bis 5-Gew.-% eines UV-Absorbers, bezogen auf die Gesamtmasse der zweiten Schicht, wobei der Brechungsindex, bestimmt nach DIN EN ISO 489 bei 23 °C und 589 nm, der zweiten Schicht um wenigstens 0,6% vom Brechungsindex der ersten Schicht abweicht,
der Brechungsindex der zweiten Schicht ist geringer als der der ersten Schicht,
der transparente Kunststoff der ersten Schicht enthält Polycarbonat und
der transparente Kunststoff der zweiten Schicht ist ein Polyalkyl(meth)acrylat.

2. Bauelement gemäß Anspruch 1, wobei die Kunststofffolie zusätzlich das Merkmal aufweist:
der Brechungsindex der zweiten Schicht weicht um wenigstens 3% vom Brechungsindex der ersten Schicht ab.

3. Bauelement gemäß Anspruch 1 oder 2, wobei die Kunststofffolie zusätzlich das Merkmal aufweist:
der transparente Kunststoff der ersten Schicht ist Polycarbonat.

4. Bauelement gemäß einem der Ansprüche 1 bis 3, wobei die Kunststofffolie zusätzlich das Merkmal aufweist:
der transparente Kunststoff der zweiten Schicht ist Polymethyl(meth)acrylat.

5. Bauelement gemäß einem der Ansprüche 1 bis 4, wobei die Kunststofffolie zusätzlich das Merkmal aufweist:
der UV-Absorber ist ein organischer UV-Absorber.

6. Bauelement gemäß einem der Ansprüche 1 bis 5, wobei die Kunststofffolie zusätzlich das Merkmal aufweist:
die erste und die zweite Schicht sind coextrudiert ausgeführt.

7. Bauelement gemäß einem der Ansprüche 1 bis 6, wobei die Kunststofffolie zusätzlich das Merkmal aufweist:
die zweite Schicht weist ein Coating auf.

8. Bauelement gemäß einem der Ansprüche 1 bis 7, wobei die Kunststofffolie zusätzlich das Merkmal aufweist:
die zweite Schicht weist eine Schichtdicke von 20 bis 60 µm, bevorzugt von 30 bis 50 µm auf.

9. Bauelement gemäß einem der Ansprüche 1 bis 8, **dadurch gekennzeichnet, dass** dieses ein Substrat umfasst, auf dem die organische Schicht angeordnet ist, wobei die Kunststofffolie auf der von der organischen Schicht abgewandten Seite des Substrats, auf derselben Seite auf der auch die organische Schicht aufgebracht ist oder auch auf beiden Seiten angeordnet ist und die erste Schicht der Kunststofffolie dem Substrat zugewandt und die zweite Schicht dem Substrat abgewandt angeordnet ist.

## Claims

1. Organic radiation-emitting component having an organic layer adapted for radiation generation and one or two radiation outcoupling sides, **characterized in that** arranged on the radiation outcoupling side(s) of the component is a plastics film having the features that:
the plastics film comprises at least a first layer of a plastics composition containing a first transparent plastic and 5% to 9% by weight of transparent, polymeric scattering particles based on the total mass of the first layer and at least a second layer of a plastics composition containing a second transparent plastic and 0.01% to 5% by weight of a UV absorber based on the total mass of the second layer, wherein the refractive index, determined according to DIN EN ISO 489 at 23°C and 589 nm, of the second layer deviates from the refractive index of the first layer by at least 0.6%,
the refractive index of the second layer is less than that of the first layer,
the transparent plastic of the first layer contains polycarbonate and
the transparent plastic of the second layer is a polyalkyl (meth)acrylate.

2. Component according to Claim 1, wherein the plastics film additionally has the feature that:
the refractive index of the second layer deviates from the refractive index of the first layer by at least 3%.

3. Component according to Claim 1 or 2, wherein the plastics film additionally has the feature that:
the transparent plastic of the first layer is polycarbonate.

4. Component according to any of Claims 1 to 3, wherein the plastics film additionally has the feature that:
the transparent plastic of the second layer is polymethyl (meth)acrylate.

5. Component according to any of Claims 1 to 4, wherein the plastics film additionally has the feature that:
the UV absorber is an organic UV absorber.

6. Component according to any of Claims 1 to 5, wherein the plastics film additionally has the feature that:
the first and the second layer are coextruded.

7. Component according to any of Claims 1 to 6, wherein the plastics film additionally has the feature that:
the second layer has a coating.

8. Component according to any of Claims 1 to 7, wherein the plastics film additionally has the feature that:
the second layer has a layer thickness of 20 to 60 µm, preferably of 30 to 50 µm.

9. Component according to any of Claims 1 to 8, **characterized in that** this comprises a substrate on which the organic layer is arranged, wherein the plastics film is arranged on the side of the substrate facing away from the organic layer, on the same side on which the organic layer is also applied or else on both sides and the first layer of the plastics film is arranged facing towards the substrate and the second layer is arranged facing away from the substrate.

## Revendications

1. Composant organique émettant un rayonnement, comprenant une couche organique configurée pour la génération d'un rayonnement et un ou deux côtés de découplage du rayonnement, **caractérisé en ce qu'**un film en matière plastique est agencé sur le ou les côtés de découplage du rayonnement du composant, qui présente les caractéristiques suivantes :
le film en matière plastique comprend au moins une première couche d'une composition de matière plastique contenant une première matière plastique transparente, ainsi que 5 à 9 % en poids de particules dispersées polymères transparentes, par rapport à la masse totale de la première couche, et au moins une deuxième couche d'une composition de matière plastique contenant une deuxième matière plastique transparente et 0,01 à 5 % en poids d'un absorbeur UV, par rapport à la masse totale de la deuxième couche, l'indice de réfraction, déterminé selon DIN EN ISO 489 à 23 °C et 589 nm, de la deuxième couche différant d'au moins 0,6 % de l'indice de réfraction de la première couche,
l'indice de réfraction de la deuxième couche est inférieur à celui de la première couche,
la matière plastique transparente de la première couche contient un polycarbonate et
la matière plastique transparente de la deuxième couche est un poly(méth)acrylate d'alkyle.

2. Composant selon la revendication 1, dans lequel le film en matière plastique présente en outre la caractéristique suivante :
l'indice de réfraction de la deuxième couche diffère d'au moins 3 % de l'indice de réfraction de la première couche.

3. Composant selon la revendication 1 ou 2, dans lequel le film en matière plastique présente en outre la caractéristique suivante :
la matière plastique transparente de la première couche est un polycarbonate.

4. Composant selon l'une quelconque des revendications 1 à 3, dans lequel le film en matière plastique présente en outre la caractéristique suivante :
la matière plastique transparente de la deuxième couche est le poly(méth)acrylate de méthyle.

5. Composant selon l'une quelconque des revendications 1 à 4, dans lequel le film en matière plastique présente en outre la caractéristique suivante :
l'absorbeur UV est un absorbeur UV organique.

6. Composant selon l'une quelconque des revendications 1 à 5, dans lequel le film en matière plastique présente en outre la caractéristique suivante :
la première et la deuxième couche sont coextrudées.

7. Composant selon l'une quelconque des revendications 1 à 6, dans lequel le film en matière plastique présente en outre la caractéristique suivante :
la deuxième couche comprend un revêtement.

8. Composant selon l'une quelconque des revendications 1 à 7, dans lequel le film en matière plastique présente en outre la caractéristique suivante :
la deuxième couche présente une épaisseur de couche de 20 à 60 µm, de préférence de 30 à 50 µm.

9. Composant selon l'une quelconque des revendications 1 à 8, **caractérisé en ce que** celui-ci comprend un substrat sur lequel la couche organique est agencée, le film en matière plastique étant agencé sur le côté opposé à la couche organique du substrat, sur le même côté que celui sur lequel la couche organique est appliquée ou également sur les deux côtés, et la première couche du film en matière plastique étant orientée vers le substrat et la deuxième couche étant opposée au substrat.
